# EUROPÄISCHE PATENTSCHRIFT

(11) **EP 3 741 562 B1**
(45) Veröffentlichungstag und Bekanntmachung des Hinweises auf die Patenterteilung: **11.01.2023**
(21) Anmeldenummer: 20168144.2
(22) Anmeldetag: 06.04.2020
(51) Int. Cl.: B32B 38/18, B32B 37/12, H05K 3/00

(54) **VERFAHREN ZUR HERSTELLUNG EINES HALBLEITERMODULS**
METHOD FOR PRODUCING A SEMICONDUCTOR MODULE
PROCÉDÉ DE FABRICATION D'UN MODULE SEMI-CONDUCTEUR

(30) Priorität: 02.05.2019 DE 102019206260
(43) Veröffentlichungstag der Anmeldung: 25.11.2020
(73) Patentinhaber: Audi AG, 85045 Ingolstadt (DE); Hitachi Energy Switzerland AG, 5400 Baden (CH)
(72) Erfinder: Lui, Chunlei, 5452 Oberrohrdorf (CH); Mohn, Fabian, 5408 Ennetbaden (CH); Schuderer, Jürgen, 8047 Zürich (CH)

(56) Entgegenhaltungen:
- EP-A2- 0 712 153
- DE-A1-102015 107 724
- DE-B3-102004 055 511
- JP-A- 2005 026 628
- US-B1- 6 274 407

## Beschreibung

Die Erfindung betrifft ein Verfahren zur Herstellung eines Halbleitermoduls, das die folgenden Schritte umfasst:
- Bereitstellen einer Trägerplatte und eines Substrats mit einer auf einer Oberfläche der Trägerplatte oder des Substrats angeordneten Bindeschicht,
- Aufbringen von Klebstoff in mehreren Klebebereichen der Trägerplatte oder des Substrats, die frei von der Bindeschicht sind,
- Positionieren des Substrats auf der Trägerplatte, derart dass das Substrat und die Trägerplatte mit der Bindeschicht und dem Klebstoff in Kontakt sind, und
- Verbinden eines Substrats und der Trägerplatte über die Bindeschicht durch Aufschmelzen oder Sintern der Bindeschicht.

Zum Antrieb einer dreiphasigen Elektromaschine mithilfe von Wechselstrom bzw. zur Bereitstellung von Gleichstrom mit Hilfe eines dreiphasigen Generators können dreiphasige Wechsel- bzw. Gleichrichter genutzt werden, die durch Halbleiterschalter gebildet werden. Hierbei kann beispielsweise eine jeweilige Halbbrücke, also ein Paar aus Halbleiterschaltern für eine jeweilige Phase, in einem gemeinsamen Gehäuse angeordnet werden und diese Gehäuse können beispielsweise auf einem gemeinsamen Kühlkörper angeordnet bzw. über eine gemeinsame Platine kontaktiert werden. Im Rahmen der Herstellung des Halbleitermoduls können die einzelnen Komponenten des Halbleitermoduls beispielsweise durch Löten oder Sintern miteinander verbunden werden und anschließend, beispielsweise durch Spritzpressen, auch Resin Transfer Molding genannt, vergossen werden. Hierbei kann das Substrat, das die Halbleiterkomponenten und Kontaktelemente zur Kontaktierung des Halbleitermoduls trägt, auf einer Trägerplatte angeordnet sein.

Werden mehrere solche Halbleitermodule zu einer Baueinheit, beispielsweise einem Gleich- oder Wechselrichter, zusammengefasst, so kann die relative Ausrichtung der Halbleitermodule zueinander durch die relative Ausrichtung ihrer Trägerplatten zueinander definiert sein. Eine Fehlpositionierung bzw. Orientierung des Substrats bezüglich der Trägerplatte kann daher dazu führen, dass die relativen Positionen der Kontakte der einzelnen Halbleitermodule zueinander von einer Sollverteilung abweichen. Sollen die einzelnen Halbleitermodule beispielsweise mittels einer Presspassung kontaktiert werden, ist es jedoch wesentlich, dass hierbei allenfalls geringe Abweichungen, beispielsweise von maximal 0,2 mm, auftreten. Eine korrekte Positionierung der aus dem Halbleitermodul geführten Kontakte bezüglich der Trägerplatte kann auch wesentlich sein, um Leckagen beim Verguss des Halbleitermoduls zu vermeiden.

Zur Verbindung des Substrats mit der Trägerplatte wird typischerweise eine Bindeschicht aufgeschmolzen, um das Substrat an die Trägerplatte zu verlöten, bzw. gesintert, um das Substrat durch Sintern mit der Trägerplatte zu verbinden. Dies kann beispielsweise dadurch erfolgen, dass Trägerplatte und Substrat gemeinsam in einem Ofen geheizt werden, während das Substrat in der korrekten Position bezüglich der Trägerplatte gehaltert ist. Die Positionierung erfolgt hierbei üblicherweise durch Rahmen oder andere Halterungen. Die Nutzung von Befestigungsrahmen ist beispielsweise in der Druckschrift CN 103894697 A beschrieben. Hierbei können verschiedene Fehlerquellen auftreten. Genutzte Rahmen greifen typischerweise an der Außenseite des Keramiksubstrats an, sodass fehlerhafte Abmessung des Keramiksubstrats, die beispielsweise bis zu 0,2 mm tragen können, auch zu Positionsfehlern der weiteren Komponenten führen. Da zudem sowohl entsprechende Rahmen bzw. Befestigungsmittel als auch die Trägerplatte bezüglich eines Drittgegenstands ausgerichtet werden müssen, können hierdurch zusätzliche Abweichungen entstehen. Um eine Beschädigung des Substrats zu vermeiden, sind zudem typischerweise Lücken von beispielsweise 0,1 mm zwischen Substrat und Rahmen erforderlich, wodurch zusätzliche Abweichungen entstehen können. Somit führen bereits die genannten kaum vermeidbaren Abweichungen dazu, dass der zulässige Toleranzbereich für die Positionierung der Kontakte bezüglich der Basisplatte bzw. andere Kontakte anderer Module weitgehend ausgeschöpft ist, sodass entweder der Herstellungsprozess von Bauteilen, die aus mehreren Halbleitermodulen aufgebaut sind, modifiziert werden muss, um größere Toleranzen zuzulassen, oder mit relativ großem Ausschuss zu rechnen ist.

Die Druckschrift DE 10 2015 107 724 A1 offenbart ein Verfahren zum Herstellen einer Substratanordnung. Ein Elektronikbauteil wird hierbei durch ein Vorfixiermittel, beispielsweise durch ein Lot oder ein Klebemittel, an einem Substrat vorfixiert und anschließend mit dem Substrat verbunden. Zum tatsächlichen Verbinden dient beispielsweise eine Sinterpaste, ein Lot, ein Leitkleber oder eine Klebefolie.

Die Druckschrift DE 10 2004 055 511 B3 schlägt vor, im Rahmen der Herstellung eines Leistungshalbleitermoduls eine Lotschicht zwischen zwei Verbindungspartner anzubringen, anschließend Fixierungsbrücken aus erstarrendem Material zwischen den Verbindungspartnern anzuordnen und auszuhärten und anschließend die Lotschicht aufzuschmelzen, um eine Lötverbindung mit exakt definierter Dicke herzustellen.

In einem Ausführungsbeispiel der Druckschrift EP 0 712 153 A2 werden Bauteile zunächst durch Klebpunkte aneinander fixiert, wonach seitlich des zu befestigten Bauteils Lötpaste aufgebraucht wird und durch ein Reflow-Verfahren in den Bereich zwischen Bauteil und Träger einfließt.

Die Druckschrift JP 2005 - 026628 A schlägt vor, ein bandförmiges Lötpreform zwischen einem Halbleiterbauteil und einem Substrat anzuordnen und diese Komponenten vor der Verlötung durch ein hitzehärtbares Harz zu verbinden.

Die Druckschrift US 6,274,407 B1 schlägt vor, zur Verbindung eines elektronischen Bauteils mit einem Substrat zunächst ein tiefschmelzendes Lötpreform an dem Substrat anzuordnen und randseitig benachbart zum Lötpreform Tropfen aus aushärtbarem Material anzuordnen.

Der Erfindung liegt somit die Aufgabe zugrunde, ein Verfahren zur Herstellung eines Halbleitermoduls anzugeben, dass eine Positionierung und Orientierung des Substrats bezüglich der Trägerplatte mit hoher Genauigkeit ermöglicht.

Die Aufgabe wird erfindungsgemäß durch ein Verfahren der eingangs genannten Art gelöst, wobei der Klebstoff in randseitigen Ausnehmungen der Bindeschicht angeordnet wird.

Es wird somit vorgeschlagen, an der Trägerplatte bzw. an dem Substrat angeordneten Klebstoff zu nutzen, um das Substrat in der korrekten Position bezüglich der Trägerplatte zu halten. Hierdurch sind keine Zusatzkomponenten, beispielsweise Rahmen oder Ähnliches, zur Halterung erforderlich. Der Klebstoff kann zunächst auf jene Komponente aufgebracht werden, die die Bindeschicht aufweist. Alternativ wäre es aber auch möglich, z.B. die Bindeschicht auf die Trägerplatte und den Klebstoff auf das Substrat aufzubringen oder umgekehrt. Wird der Klebstoff auf die Komponente ohne Bindeschicht aufgebracht, können die Klebebereiche so gewählt sein, dass der Klebstoff nach dem Positionieren des Substrats die die Bindeschicht aufweisende Komponente in Bereichen kontaktiert, die frei von der Bindeschicht sind.

Die Trägerplatte mit dem darauf angeklebten Substrat kann anschließend beispielsweise problemlos in einen Ofen oder Ähnliches transferiert werden, um die Bindeschicht für eine Verlötung aufzuschmelzen oder zu sintern. Hierdurch kann die Genauigkeit der Positionierung des Substrats bezüglich der Trägerplatte erhöht werden. Hieraus resultiert auch eine genauere Positionierung und Orientierung von Kontakten bezüglich der Basisplatte, wodurch einerseits Leckagen beim Vergießen vermieden werden können und andererseits problemlos mehrere der Halbleitermodule mit hoher Genauigkeit beispielsweise mit einer gemeinsamen Steuerplatine gekoppelt werden können. Es kann auch erreicht werden, dass das Substrat im Wesentlichen deckungsgleich mit einer zu sinternden Verbindungsschicht ist, wodurch vermieden werden kann, dass Teil der zu sinternden Verbindungsschicht freiliegen und daher mit geringerem Druck gesintert werden, was zu losen Partikeln der Sintermaße, beispielsweise von Silber oder Kupfer, führen könnte.

Das Aufbringen der Bindeschicht auf die Trägerplatte kann in einem vorgelagerten Schritt vor Beginn des erfindungsgemäßen Verfahrens erfolgen, jedoch als separater Schritt innerhalb des erfindungsgemäßen Verfahrens bewerkstelligt werden. Die Bindeschicht kann beispielsweise aus einem Lot bzw. eine Lötpaste bestehen, um eine Lötverbindung zwischen Bindeschicht und Substrat durch Aufschmelzen der Bindeschicht zu erreichen. Alternativ kann die Bindeschicht die Verbindung durch eine Sintern herstellen, wozu beispielsweise eine Kupfer- oder Silber-Sinterpaste verwendet werden kann.

Die Fläche der Klebebereiche kann wenigstens um den Faktor 20 oder wenigstens um den Faktor 100 oder wenigstens um den Faktor 500 kleiner als die Fläche des Substrats bzw. der Bindeschicht sein. Vorzugsweise werden die Klebebereiche zudem im Randbereich des Substrats bzw. der Bindeschicht vorgesehen. Somit können die Klebebereich relativ weit von auf dem Substrat aufgebrachten Halbleiterchips entfernt sein, wodurch die Kühlung dieser Halbleiterchips über die Trägerplatte durch Nutzung des Klebstoffs im Wesentlichen nicht beeinflusst wird. Wie später noch genauer erläutert werden wird, kann der Klebstoff im Rahmen der Herstellung des Halbleitermoduls zudem vollständig oder zumindest weitgehend verdampft werden, sodass er im fertiggestellten Modul das Betriebsverhalten des Halbleitermoduls letztlich nicht beeinflusst.

Die Abmessungen der Bindeschicht können im Wesentlichen den Abmessungen des Substrats entsprechen. Insbesondere kann die Summe der Fläche der Klebebereiche und der Fläche der Bindeschicht gleich oder etwas kleiner als die Fläche des Substrats sein. Hierdurch kann, wie obig erläutert, vermieden werden, dass Teile der Bindeschicht nach dem Aufbringen des Substrats freiliegen, was bei einer Sinterverbindung zu freien Partikeln aufgrund eines mangelnden Drucks während des Sinterns und bei Nutzung einer Lötverbindung zu einem Austritt von Lot aus dem relevanten Bereich führen könnte. Nach dem Anbringen des Substrats an der Trägerplatte und von Halbleiterkomponenten bzw. Halbleiterchips und Kontakten auf dem Substrat kann das resultierende Halbleitermodule vergossen werden, beispielsweise durch Spritzpressen. Mehrere so hergestellte Halbleitermodule können anschließend beispielsweise genutzt werden, um einen Gleich- oder Wechselrichter aufzubauen. Als Klebstoff kann ein Schmelzklebstoff verwendet werden. Beispielsweise kann der Klebstoff so gewählt werden, dass er eine Schmelztemperatur zwischen 60 °C und 140 °C, beispielsweise von 100 °C, aufweist. Es ist möglich, dass der Klebstoff eine Verdampftemperatur von zwischen 160 °C und 300 °C, insbesondere von mehr als 200 °C, aufweist.

Das Positionieren des Substrats auf der Trägerplatte kann bei einer Temperatur erfolgen, bei der der Klebstoff flüssig ist. Beispielsweise kann der Klebstoff bei Raumtemperatur fest sein, sodass durch ein Auskühlen des Klebstoffs nach dem Positionieren des Substrats das Substrat, beispielsweise bei einem Transfer der Trägerplatte mit dem daran angeordneten Substrat zu einem weiteren Verarbeitungsschritt, nicht bezüglich der Trägerplatte beweglich ist. Bei dem Positionieren des Substrats kann beispielsweise die Trägerplatte ausreichend aufgeheizt werden, um den Klebstoff zu verflüssigen. Wird, wie obig erläutert, einen Klebstoff mit relativ niedriger Schmelztemperatur verwendet, ist dies problemlos innerhalb von Bestückungsautomaten oder anderen zum Positionieren des Substrats geeigneten Vorrichtungen möglich.

Zu einem Aufschmelzen oder Sintern der Bindeschicht können Temperaturen verwendet werden, die oberhalb der Siedetemperatur des Klebstoffs liegen. Dies führt dazu, dass der Klebstoff während des Aufschmelzens bzw. Sinterns zumindest teilweise verdampft. Der Klebstoff kann somit vollständig oder zumindest teilweise rückstandsfrei entfernt werden, womit vermieden werden kann, dass er das weitere Betriebsverhalten des Halbleitermoduls beeinflusst. Auch wenn der Klebstoff im Rahmen des Aufschmelzens oder Sinterns weitgehend oder sogar vollständig verdampft, ist in dem resultierenden Produkt, also dem hergestellten Halbleitermodul, typischerweise dennoch erkennbar, dass ein Klebstoff zur vorübergehenden Fixierung des Substrats an der Trägerplatte genutzt wurde. In dem erfindungsgemäßen Verfahren ist der Klebstoff in den Klebbereichen der Trägerplatte angeordnet, die frei von der Bindeschicht sind. Bei einer Nutzung eines Sintermaterials als Bindeschicht bleiben diese Bereiche auch beim Sintern frei, sodass auch im hergestellten Halbleitermodul erkennbar ist, dass diese Bereiche freigehalten wurden, um im Rahmen der Herstellung Klebstoff zu nutzen. Besteht die Bindeschicht aus einem Lot, so verläuft dieses zwar beim Aufschmelzen, dennoch wird typischerweise in jenen Bereichen, die zunächst frei waren und in denen Klebstoff angeordnet war, eine geringere Benetzung auftreten. Somit sind auch im hergestellten Halbleitermodul Klebebereiche durch ihre schlechtere Benetzung mit Lot erkennbar.

In dem erfindungsgemäßen Verfahren kann ein Bestückungsautomat verwendet werden, um das Substrat auf der Trägerplatte zu positionieren. Die Positionierung kann durch einen Pick and Place Prozess erfolgen, der insbesondere auch aus dem Bereich der SMD-Technik bekannt ist. Hierdurch kann eine hoch genaue Positionierung und Orientierung erreicht werden und insbesondere eine höhere Genauigkeit der Position und Orientierung als bei einer rahmenbasierten Positionierung des Substrats auf der Trägerplatte.

Der Klebstoff wird in randseitigen Ausnehmungen der Bindeschicht angeordnet. Anders ausgedrückt ist es möglich, dass die Bindeschicht die Klebebereiche in der Ebene der Bindeschicht nicht allseitig umgreift. Hierdurch wird ermöglicht, dass der Klebstoff, insbesondere nach einem Verdampfen, aus dem Bereich zwischen Substrat und Trägerplatte austreten kann.

Die Klebebereiche können in Ausnehmungen einer rechteckigen Bindeschicht angeordnet werden, die am Rand und/oder an wenigstens eine Ecke der Bindeschicht angeordnet sind. Allgemein ausgedrückt kann der Klebebereich wenigstens eine freie Seite aufweisen, an der keine benachbarte Bindeschicht angeordnet ist.

Als Klebstoff kann ein Kunststoff mit einer Schmelztemperatur zwischen 60°C und 140°C und einer Verdampftemperatur zwischen 160°C und 300°C verwendet werden.

Als Halbleitermodul kann eine Halbbrücke hergestellt werden oder es können mehrere Halbleitermodule hergestellt werden, die jeweils Halbbrücken sind und die als Komponente eines Halbleiterbauteils verwendet werden, das ein Gleichrichter oder Wechselrichter ist. Anders ausgedrückt kann das erfindungsgemäße Verfahren auch Teil eines Verfahrens zur Herstellung eines Gleichrichters bzw. Wechselrichters sein. Gleich- und Wechselrichter, die auf Halbleiterschalten basieren, können technisch gleich aufgebaut sein und sich ausschließlich bezüglich einer Steuerung und somit bezüglich ihrer Leistungstransferrichtung unterscheiden. Das hergestellte Halbleiterbauteil kann somit bedarfsgerecht als Gleichrichter oder Wechselrichter genutzt werden. Die Ausgestaltung von Halbbrücken bzw. der Aufbau von Gleich- oder Wechselrichter aus solchen Halbbrücken sind im Stand der Technik bekannt und sollen nicht detailliert erläutert werden. Wie bereits eingangs erläutert, ist es hierfür jedoch besonders relevant, dass die Kontakte der verschiedenen Halbleitermodule mit hoher Genauigkeit zueinander ausgerichtet werden können, um eine einfache Kontaktierung bzw. gemeinsame Kühlung der Module zu erreichen.

Neben dem erfindungsgemäßen Verfahren wird ein Halbleitermodul offenbart, umfassend ein Halbleiterkomponenten tragendes Substrat, das über eine Bindeschicht mit einer Trägerplatte verbunden ist, wobei das Halbleitermodul derart hergestellt ist, dass das Substrat vor dem Verbinden des Substrats und der Trägerplatte über die Bindeschicht zunächst durch einen Klebstoff an der Trägerplatte gehaltert ist. Hierbei ist es möglich, dass Rückstände des Klebstoffs in dem Halbleitermodul verbleiben, wodurch eine entsprechende Herstellung des Halbleitermoduls nachgewiesen werden kann. Wie bereits zum erfindungsgemäßen Verfahren erläutert, ist es jedoch auch möglich, dass der Klebstoff im Rahmen der Herstellung beispielsweise verdampft und somit vollständig oder zumindest weitergehend aus dem fertigen Halbleitermodul entfernt ist. Wie obig erläutert kann die Nutzung des Klebstoffs dennoch anhand der Verteilung der Bindeschicht bzw. der Benetzung der Trägerplatte durch die Bindeschicht erkannt werden.

Insbesondere ist es bei dem offenbarten Halbleitermodul somit möglich, dass die Bindeschicht randseitige Ausnehmungen oder Bereiche geringer Benetzung aufweist. Diese sind die jene Bereiche, die ursprünglich Ausnehmungen bildeten, in denen die Klebebereiche angeordnet waren.

Offenbart wird zudem einen Gleich- und/oder Wechselrichter, der drei erfindungsgemäße Halbleitermodule aufweist, die jeweils eine Halbbrücke ausbilden. Wie bereits obig erläutert, ist die durch den Klebstoff erreichbare Exaktheit der Positionierung und Orientierung des Substrats bezüglich der Trägerplatte insbesondere für diese Anwendung relevant.

Zudem wird ein Kraftfahrzeug offenbart, das wenigstens ein obig offenbartes Halbleitermodul und/oder wenigstens einen offenbartes Gleich- und/oder Wechselrichter umfasst. Der Gleich- bzw. Wechselrichter kann insbesondere dazu dienen, Wechselspannung, insbesondere dreiphasige Wechselspannung, für eine elektrische Maschine des Kraftfahrzeugs, insbesondere einen Antriebsmotor, bereitzustellen. Alternativ oder ergänzend kann er dazu dienen, bei einem Generatorbetrieb der elektrischen Maschine einen Gleichstrom bereitzustellen, beispielsweise um ein Fahrzeugnetz zu speisen bzw. eine Batterie des Kraftfahrzeugs zu laden.

Weitere Vorteile und Einzelheiten der Erfindung ergeben sich aus den folgenden Ausführungsbeispielen sowie den zugehörigen Zeichnungen. Hierbei zeigt schematisch:
- Fig. 1: ein Halbleitermodul,
- Fig. 2-3: verschiedene Schritte im Rahmen eines Ausführungsbeispiels des erfindungsgemäßen Verfahrens zur Herstellung eines Halbleitermoduls,
- Fig.4: eine alternative Anordnung der Klebebereiche in einem weiteren Ausführungsbeispiel des erfindungsgemäßen Verfahrens, und
- Fig. 5: ein Kraftfahrzeugs, das einen Gleich- und Wechselrichters umfasst.

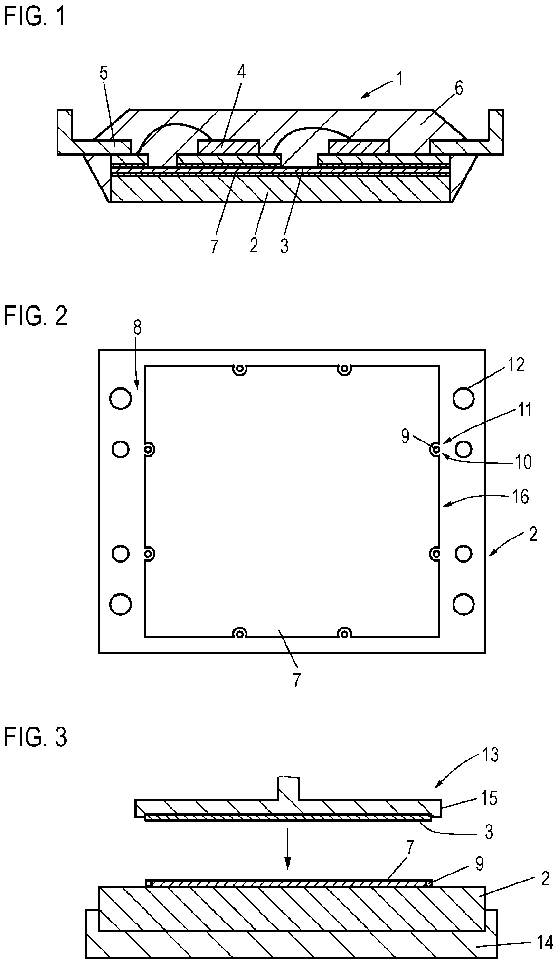

Fig. 1 zeigt ein Ausführungsbeispiel eines Halbleitermoduls 1, das ein Substrat 3 umfasst, das die Halbleiterkomponenten 4, beispielsweise Halbleiterchips, und Kontaktelemente 5 trägt. Das Substrat 3 ist über eine Bindeschicht 7 mit einer Trägerplatte 2 verbunden, beispielsweise durch Sintern oder Löten. Anschließend können die genannten Komponenten durch eine Vergussmasse 6, beispielsweise durch Spritzpressen, vergossen werden.

Das Halbleitermodul 1 kann insbesondere eine Halbbrücke sein, wobei, wie später noch genauer erläutert werden wird, drei dieser Halbbrücken zu einem Gleich- bzw. Wechselrichter für dreiphasige Wechselspannungen zusammengefasst werden können. Hierbei kann es beispielsweise gewünscht sein, die drei genutzten Halbleitermodule 1 an einem gemeinsamen Kühlkörper anzuordnen und ihrer Kontaktelemente 5 über eine gemeinsame Platine, beispielsweise durch eine Presspassung, zu kontaktieren. Es ist somit hochgradig relevant, dass die Positionen und Orientierungen der Kontaktelemente 5 bezüglich der Trägerplatte 2 mit hoher Genauigkeit vorgegeben werden können.

Ein begrenzender Faktor kann hierbei sein, mit welcher Genauigkeit das Substrat 3 an der Trägerplatte 2 angebracht werden kann. Um hierbei eine hohe Genauigkeit zu erreichen, ist das Halbleitermodule 1 derartig hergestellt, dass das Substrat 3 vor dem Verbinden des Substrats 3 und der Trägerplatte 2 über die Bindeschicht 7 zunächst durch einen Klebstoff an der Trägerplatte 2 gehaltert ist. Es ist hierbei möglich, dass der Klebstoff im Rahmen der Herstellung weitgehend oder gar vollständig verdampft, sodass im fertigen Halbleitermodul 1 kein Klebstoff verbleibt. Die Nutzung des Klebstoffs im Rahmen der Herstellung kann jedoch bei Nutzung einer gesinterten Bindeschicht 7 an der Form der Sinterschicht 7 bzw. bei Nutzung einer Verbindungsschicht 7 aus Lot dadurch erkannt werden, dass Bereiche der Trägerplatte 2, in denen der Klebstoff angeordnet war, weniger gut benetzt sind.

Das Verfahren zur Herstellung des Halbleitermoduls 1 wird im Folgenden mit Bezug auf die Figuren 2 und 3 näher erläutert. Hierbei wird zunächst eine Trägerplatte 2 mit einer an der Oberfläche 8 der Trägerplatte 2 angeordneten Bindeschicht 7 bereitgestellt. Die Bindeschicht 7 kann im Rahmen des Verfahrens oder in einem vorbereitenden Schritt aufgebracht werden. Um eine genaue Positionierung und Orientierung der Trägerplatte 2 bezüglich genutzter Werkzeuge zu ermöglichen, sind an dieser mehrere randseitige Durchbrechungen 12 vorgesehen. Die Bindeschicht 7 kann beispielsweise aus Lötpaste oder einer Kupfer- oder Silber-Sinterpaste bestehen.

Wie vorangehend erläutert, soll das Substrat 3 zunächst durch Klebstoff 9 an der Trägerplatte gehaltert werden. Daher weist die Bindeschicht 7 an ihren Rändern 16 jeweils randseitige Ausnehmungen 11 auf, in denen die Oberfläche 8 der Trägerplatte 2 freiliegt. In Klebebereichen 10 innerhalb dieser Ausnehmungen 11 wird zunächst Klebstoff, vorzugsweise Schmelzklebstoff, aufgebracht. Vorzugsweise werden entsprechende Klebepunkte maschinell aufgebracht. Es wird ein Klebstoff 9 genutzt, der bei Raumtemperatur fest ist. Es ist daher möglich, dass der Klebstoff 9 zunächst an der Trägerplatte 2 aushärtet, bevor eine Weiterverarbeitung erfolgt.

In einer nicht dargestellten Alternative wäre es auch möglich die Bindeschicht 7 und/oder den Klebstoff 9 an dem Substrat 3 statt an der Trägerplatte 2 anzuordnen.

In einem folgenden Verarbeitungsschritt wird, wie in Fig. 3 dargestellt ist, das Substrat 3 derart an der Trägerplatte 2 angeordnet, dass das Substrat 3 und die Trägerplatte 2 beide mit der Bindeschicht 7 und dem Klebstoff 9 in Kontakt sind. Das Positionieren des Substrats 3 auf der Trägerplatte 2 erfolgt hierbei bei einer Temperatur, bei der der Klebstoff flüssig ist, beispielsweise 100 °C. Zur Positionierung des Substrats 3 kann ein Bestückungsautomat 13 verwendet werden, von dem in Fig. 3 schematisch nur eine Halterung 14 für die Trägerplatte 2 und ein Bestückungselement 15, das das Substrat 3 haltert, gezeigt sind. Entsprechende Bestückungsautomaten sind beispielsweise aus dem Bereich der SMD-Bestückung bekannt und können genutzt werden, um Komponenten mit hoher Genauigkeit zu platzieren.

Nach dem Positionieren des Substrats 3 auf der Trägerplatte 2 kann die Temperatur reduziert werden, sodass der Klebstoff 9 aushärtet und die Trägerplatte 2 mit hoher Genauigkeit an einer definierten Position und mit einer definierten Orientierung bezüglich der Trägerplatte 2 haltert.

Die Trägerplatte 2 mit dem hieran angeklebten Substrat 3 kann anschließend in einen Ofen oder zu einer anderen Heizeinrichtung transferiert werden. Dort kann die Temperatur, insbesondere unter Ausübung von einem Druck auf das Substrat 3, erhöht werden, um das Substrat 3 und die Trägerplatte 2 durch Sintern der Bindeschicht 7 zu verbinden bzw. die Bindeschicht 7 aufzuschmelzen, um Substrat 3 mit der Trägerplatte zu verlöten. Hierbei werden vorzugsweise Temperaturen verwendet, die oberhalb der Siedetemperatur des Klebstoffs 9 liegen. Der Klebstoff 9 kann somit im Rahmen des Sinterns bzw. Aufschmelzens verdampfen und, da er randseitig bezüglich der Bindeschicht 7 angeordnet ist, seitlich aus dem Spalt zwischen Trägerplatte 2 und Substrat 3 entweichen. Hierdurch ist es möglich, dass der Klebstoff 9 zumindest weitgehend rückstandsfrei entfernt wird. Da sich die Form der Bindeschicht 7 parallel zur Oberfläche 8 der Trägerplatte 2 jedoch beim Sintern im Wesentlichen nicht ändert, kann nach einem Sintern weiterhin klar erkannt werden, dass die Bindeschicht 7 die Ausnehmungen 11 aufweist, was auf eine Nutzung von Klebstoff 9 zur Herstellung hinweist. Auch bei einer Nutzung eines Lots als Bindeschicht 7, das aufgeschmolzen wird, ist typischerweise klar erkennbar, dass die Trägerplatte 2 im Bereich der Ausnehmungen 11 bzw. in den Klebebereichen 10 schlechter benetzt ist, als in den anderen Bereichen. Auch dies deutet eine Klebstoffnutzung bei der Herstellung des Halbleitermoduls 1 hin.

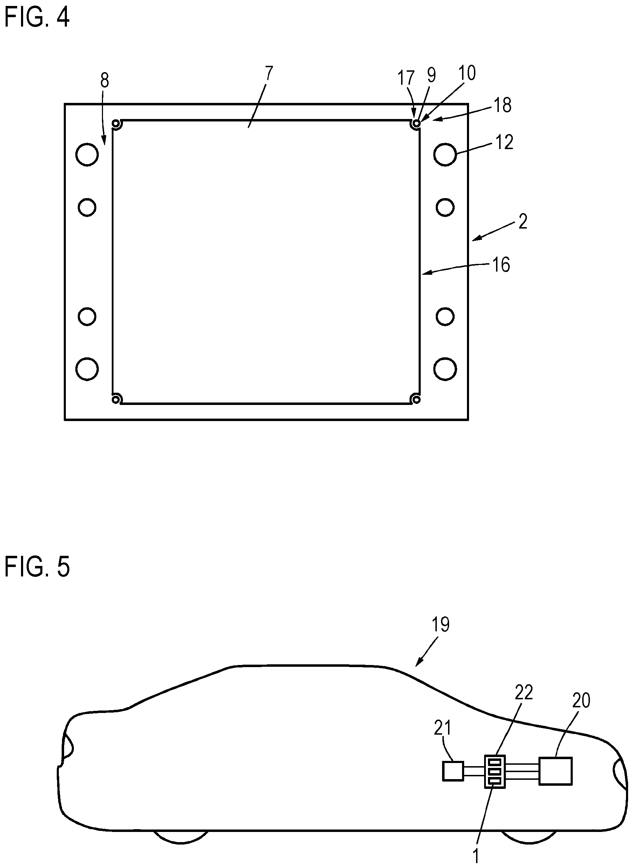

Die in Fig. 2 dargestellte Anordnung der Klebebereiche 10 in Ausnehmungen 11 der Ränder 16 ist rein beispielhaft. Selbstverständlich ist es möglich, mehr oder weniger Klebebereiche zu nutzen, von der in Fig. 2 gezeigten symmetrischen Verteilung abzuweichen oder Ähnliches. Eine randseitige Anordnung von Klebebereichen 10 sind insbesondere auch in Ausnehmungen 17 an Ecken 18 der Bindeschicht 7 möglich, wie in Fig. 4 dargestellt ist. Eine Anordnung vom Klebstoff 9 an Ecken 18 kann ergänzend oder alternativ zu der in Fig. 2 dargestellten Anordnung genutzt werden.

Fig. 5 zeigt die Nutzung eines entsprechend hergestellten Halbleitermoduls 1 in einem Kraftfahrzeug 19. Hierbei wird durch das Halbleitermoduls 1 jeweils eine Halbbrücke implementiert und drei diese Halbbrücken werden in einem Gleich- und Wechselrichter 22 zusammengefasst. Ein Aufbau eines Gleichund Wechselrichters aus mehreren Halbbrückenmodulen ist im Stand der Technik prinzipiell bekannt und soll nicht detailliert erläutert werden. Relevant ist hierbei, dass es vorzugsweise möglich sein soll, mehrere der Halbleitermodule 1 an einem gemeinsamen Kühlkörper anzubringen bzw. mit einer gemeinsamen Platine zu kontaktieren. Daher ist es erforderlich, dass die Kontaktelemente 5 der verschiedenen Halbleitermodule 1 eine definierte relative Anordnung zueinander aufweisen. Hierfür ist es wiederum erforderlich, dass die Kontaktelemente 5 und somit auch das Substrat 3 mit hoher Genauigkeit bezüglich der Trägerplatte 2 angeordnet werden, was durch das vorangehend beschriebene Vorgehen erreicht werden kann.

Das Kraftfahrzeug 19 umfasst eine Elektromaschine 22, insbesondere eine Antriebsmaschine des Kraftfahrzeugs 19, die durch eine Batterie 21 oder eine andere Gleichstromquelle, beispielsweise ein Fahrzeugnetz, versorgt werden soll. Um die Gleichspannung der Batterie 21 bzw. des Fahrzeugnetzes in einer dreiphasigen Wechselspannung umzusetzen, wird der Gleich- und Wechselrichter 22 genutzt. Dieser kann zudem dazu genutzt werden, um bei einem Generatorbetrieb der Elektromaschine 20 Gleichstrom für die Batterie 21 bzw. das Fahrzeugnetz bereitzustellen.

## Patentansprüche

1. Verfahren zur Herstellung eines Halbleitermoduls (1), umfassend die Schritte:
- Bereitstellen einer Trägerplatte (2) und eines Substrats (3) mit einer auf einer Oberfläche (8) der Trägerplatte (2) oder des Substrats (3) angeordneten Bindeschicht (7),
- Aufbringen von Klebstoff (9) in mehreren Klebebereichen (10) der Trägerplatte (2) oder des Substrats (3), die frei von der Bindeschicht (7) sind,
- Positionieren des Substrats (3) auf der Trägerplatte (2), derart dass das Substrat (3) und die Trägerplatte (2) mit der Bindeschicht (7) und dem Klebstoff (9) in Kontakt sind,
- Verbinden des Substrats (3) und der Trägerplatte (2) über die Bindeschicht (7) durch Aufschmelzen oder Sintern der Bindeschicht (7),
**dadurch gekennzeichnet,**
**dass** der Klebstoff (9) in randseitigen Ausnehmungen (11, 17) der Bindeschicht (7) angeordnet wird.

2. Verfahren nach Anspruch 1,
**dadurch gekennzeichnet,**
**dass** das Positionieren des Substrats (3) auf der Trägerplatte (2) bei einer Temperatur erfolgt, bei der der Klebstoff (9) flüssig ist.

3. Verfahren nach Anspruch 1 oder 2,
**dadurch gekennzeichnet,**
**dass** zu dem Aufschmelzen oder Sintern der Bindeschicht (7) Temperaturen verwendet werden, die oberhalb der Siedetemperatur des Klebstoffs (9) liegen.

4. Verfahren nach einem der vorangehenden Ansprüche,
**dadurch gekennzeichnet, dass** ein Bestückungsautomat (13) verwendet wird, um das Substrat (3) auf der Trägerplatte (2) zu positionieren.

5. Verfahren nach einem der vorangehenden Ansprüche,
**dadurch gekennzeichnet, dass** als Klebstoff (9) ein Kunststoff mit einer Schmelztemperatur zwischen 60°C und 140°C und einer Verdampftemperatur zwischen 160°C und 300°C verwendet wird.

6. Verfahren nach einem der vorangehenden Ansprüche,
**dadurch gekennzeichnet,**
**dass** als Halbleitermodul (1) eine Halbbrücke hergestellt wird oder dass mehrere Halbleitermodule (1) hergestellt werden, die jeweils Halbbrücken sind und die als Komponenten eines Halbleiterbauteils verwendet werden, das ein Gleichrichter oder Wechselrichter (22) ist.

## Claims

1. Method for manufacturing a semiconductor module (1), comprising the steps:
- providing a carrier plate (2) and a substrate (3) having a bonding layer (7) arranged on a surface (8) of the carrier plate (2) or of the substrate (3),
- applying adhesive (9) in several adhesive regions (10) of the carrier plate (2) or of the substrate (3) which are free of bonding layer (7),
- positioning the substrate (3) on the carrier plate (2) such that the substrate (3) and the carrier plate (2) are in contact with the bonding layer (7) and the adhesive (9),
- connecting the substrate (3) and the carrier plate (2) by way of the bonding layer (7) by melting or sintering the bonding layer (7),
**characterised in that**
the adhesive (9) is arranged in cutouts (11, 17) on the edges of the bonding layer (7).

2. Method according to claim 1,
**characterised in that**
the positioning of the substrate (3) on the carrier plate (2) takes place at a temperature at which the adhesive (9) is liquid.

3. Method according to claim 1 or 2
**characterised in that**
for melting or sintering the bonding layer (7), temperatures are used which lie above the boiling temperature of the adhesive (9).

4. Method according to any of the preceding claims,
**characterised in that** a pick-and-place machine (13) is used to position the substrate (3) on the carrier plate (2).

5. Method according to any of the preceding claims,
**characterised in that** as an adhesive (9), an adhesive is used which has a melting temperature between 60°C and 140°C and an evaporation temperature of between 160°C and 300°C.

6. Method according to any of the preceding claims,
**characterised in that**
as a semiconductor module (1) a half-bridge is manufactured or that several semiconductor modules (1) are manufactured which are in each case half-bridges and which are used as components of a semiconductor component which is a rectifier or inverter (22).

## Revendications

1. Procédé de fabrication d'un module semi-conducteur (1), comprenant les étapes consistant à :
- préparer une plaque de support (2) et un substrat (3) avec une couche de liaison (7) agencée sur une surface (8) de la plaque de support (2) ou du substrat (3),
- appliquer de l'adhésif (9) dans plusieurs zones de collage (10) de la plaque de support (2) ou du substrat (3) qui sont exemptes de la couche de liaison (7),
- positionner le substrat (3) sur la plaque de support (2) de sorte que le substrat (3) et la plaque de support (2) soient en contact avec la couche de liaison (7) et l'adhésif (9),
- assembler le substrat (3) et la plaque de support (2) par l'intermédiaire de la couche de liaison (7) en faisant fondre ou en frittant la couche de liaison (7),
**caractérisé en ce que**
l'adhésif (9) est agencé dans des évidements marginaux (11, 17) de la couche de liaison (7).

2. Procédé selon la revendication 1,
**caractérisé en ce que**
le positionnement du substrat (3) sur la plaque de support (2) est effectué à une température à laquelle l'adhésif (9) est liquide.

3. Procédé selon la revendication 1 ou 2,
**caractérisé en ce que**
on utilise, pour la fusion ou le frittage de la couche de liaison (7), des températures qui sont supérieures à la température d'ébullition de l'adhésif (9).

4. Procédé selon l'une quelconque des revendications précédentes,
**caractérisé en ce qu'**une machine de placement automatique (13) est utilisée pour positionner le substrat (3) sur la plaque de support (2).

5. Procédé selon l'une quelconque des revendications précédentes,
**caractérisé en ce que** l'on utilise comme adhésif (9) une matière plastique présentant une température de fusion comprise entre 60 °C et 140 °C et une température d'évaporation comprise entre 160 °C et 300 °C.

6. Procédé selon l'une quelconque des revendications précédentes,
**caractérisé en ce que**
un demi-pont est fabriqué comme module semi-conducteur (1) ou plusieurs modules semi-conducteurs (1) sont fabriqués, qui sont respectivement des demi-ponts et qui sont utilisés comme composants d'un composant semi-conducteur, qui est un redresseur ou un onduleur (22).
